# EUROPÄISCHE PATENTSCHRIFT

(11) **EP 4 323 845 B1**
(45) Veröffentlichungstag und Bekanntmachung des Hinweises auf die Patenterteilung: **19.11.2025**
(21) Anmeldenummer: 22717107.1
(22) Anmeldetag: 21.03.2022
(51) Int. Cl.: G05B 19/042

(54) **VERFAHREN ZUM ÜBERPRÜFEN EINES SIGNALPFADES EINER ELEKTRONISCHEN SENSORSCHALTUNG FÜR EIN FELDGERÄT DER AUTOMATISIERUNGSTECHNIK**
METHOD FOR CHECKING A SIGNAL PATH OF AN ELECTRONIC SENSOR CIRCUIT FOR A FIELD DEVICE IN AUTOMATION TECHNOLOGY
PROCÉDÉ DE CONTRÔLE D'UN TRAJET DE SIGNAL D'UN CIRCUIT DE CAPTEUR ÉLECTRONIQUE POUR UN APPAREIL DE TERRAIN DANS UNE TECHNOLOGIE D'AUTOMATISATION

(30) Priorität: 14.04.2021 DE 102021109398
(43) Veröffentlichungstag der Anmeldung: 21.02.2024
(73) Patentinhaber: Endress+Hauser SE+Co. KG, 79689 Maulburg (DE)
(72) Erfinder: MÜLLER, Stefan, 79312 Emmendingen (DE); DOHSE, Dirk, 79102 Freiburg (DE); HAMMER, Manfred, 79664 Wehr (DE)
(74) Vertreter: Endress + Hauser Group Services (Deutschland) AG+Co. KG
(86) Internationale Anmeldenummer: PCT/EP2022/057298
(87) Internationale Veröffentlichungsnummer: WO 2022/218644

(56) Entgegenhaltungen:
- EP-A1- 3 961 228
- WO-A1-2016/026620
- DE-A1- 102016 125 240

## Beschreibung

Die Erfindung bezieht sich auf ein Verfahren zum Überprüfen eines Signalpfades einer elektronischen Sensorschaltung für ein Feldgerät der Automatisierungstechnik.

In der Prozessautomatisierungstechnik ebenso wie in der Fertigungsautomatisierungstechnik werden vielfach Feldgeräte eingesetzt, die zur Erfassung und/oder Beeinflussung von Prozessgrößen dienen. Zur Erfassung von Prozessgrößen dienen Messgeräte bzw. Sensoren, wie beispielsweise Füllstandsmessgeräte, Durchflussmessgeräte, Druck- und Temperaturmessgeräte, pH-Redoxpotentialmessgeräte, Leitfähigkeitsmessgeräte, etc., welche die entsprechenden Prozessvariablen Füllstand, Durchfluss, Druck, Temperatur, pH-Wert bzw. Leitfähigkeit erfassen. Zur Beeinflussung von Prozessgrößen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann.

Eine Vielzahl solcher Feldgeräte wird von der Endress + Hauser-Gruppe hergestellt und vertrieben.

Derartige Feldgeräte weisen für gewöhnlich eine elektronische Sensorschaltung auf, welche an sich bekannt sind. Die elektronische Sensorschaltung wird bei den Feldgeräten eingesetzt, um Rohmesswerte, also Messwerte die nicht kompensiert, insbesondere nicht temperaturkompensiert sind, weiterverarbeiten zu können. Beispielsweise wird über ein analoges elektrisches Wandlerelement eine Prozessgröße in Form von Rohmesswerten erfasst und die analogen Rohmesswerte über einen Analog-Digital-Konverter digitalisiert, um anschließend die digitalisierten Rohmesswerte über einen digitalen Prozessor zu (digitalen) Messwerten zu verarbeiten. Hierbei kann über den digitalen Prozessor eine Reihe von Operationen mit den Rohmesswerten durchgeführt werden. Beispielsweise kann eine Temperaturkompensation der Rohmesswerte durchgeführt werden, um ein (temperaturkompensiertes) digitales Ausgangssignal in Form von Messwerten zu erhalten. Die Verarbeitung des analogen Rohmesswertes entlang der Kette von dem Wandlerelement bis hin zu dem Ausgang des digitalen Prozessors wird hierbei auch als Signalpfad bezeichnet.

In der Praxis werden Feldgeräte in Industrieanlagen zum Teil extremen Bedingungen ausgesetzt, die über die Lebensdauer der elektronischen Schaltung den Signalpfad negativ beeinflussen können.

Beispielsweise können extreme Temperaturschwankungen, Vibrationen, Feuchtigkeit oder EMV die elektrischen bzw. mechanischen Eigenschaften des Signalpfades negativ beeinflussen und somit einen negativen Effekt auf die Messfunktion bzw. der Messgenauigkeit haben.

WO 2016/026620 A1 offenbart ein bekanntes Verfahren zum Überprüfen eines Feldgerätes mit einer Messsignalverarbeitung.

Der Erfindung liegt somit die Aufgabe zugrunde, eine Möglichkeit vorzuschlagen mittels derer ein Signalpfad einer elektronischen Schaltung eines Feldgerätes überprüft bzw. überwacht werden kann.

Die Aufgabe wird erfindungsgemäß gelöst durch das Verfahren gemäß Patentanspruch 1.

Das erfindungsgemäße Verfahren zum Überprüfen eines Signalpfades einer elektronischen Sensorschaltung für ein Feldgerät der

Automatisierungstechnik, wobei die Sensorschaltung wenigstens einen Signalpfad mit zumindest einem Wandlerelement zum Erfassen, Wandeln und Ausgeben einer Prozessgröße an einem Ausgang des Wandlerelements in Form von analogen Rohmesswerten, einem dem Wandlerelement nachgeschalteten Analog-Digital-Konverter zum Wandeln der analogen Rohmesswerte in digitale Rohmesswerte und einem dem Analog-Digital-Konverter nachgeschalteten digitalen Prozessor, insbesondere einen digitalen Signalprozessor, dem die digitalisierten Rohmesswerte zugeführt sind und der digitale Prozessor dazu eingerichtet ist, in einem Messbetrieb, die digitalisierten Rohmesswerte zu Messwerten weiterzuverarbeiten, umfasst, sieht die folgende Schritte vor:
- Unterbrechen des Messbetriebes;
- Ersetzen der analogen Rohmesswerte an dem Ausgang des Wandlerelements durch ein analoges Überprüfungssignal;
- Durchlaufen des Signalpfads mit dem analogen Überprüfungssignal, so dass der digitale Prozessor einen für das analoge Überprüfungssignal entsprechenden Messwert ermittelt;
- Überprüfen des ermittelten Messwertes mit einem für den Signalpfad ermittelten Vergleichswert, wobei in dem Fall, dass der für das analoge Überprüfungssignal ermittelte Messwert außerhalb eines für den Vergleichswert festgelegten Toleranzbereiches liegt, eine Veränderung des Zustandes des Signalpfads festgestellt wird.

Erfindungsgemäß wird ein Verfahren vorgeschlagen, bei dem die im Messbetrieb zum Bestimmen eines Messwertes verwendeten analogen Rohmesswerte, die von dem Wandlerelement stammen, durch ein analoges Überprüfungssignal ersetzt werden. Dieses Überprüfungssignal stellt somit quasi ein "simuliertes" Signal dar, welches dann für die dem Wandlerelement folgenden Elemente des Signalpfads verwendet wird. Basierend auf diesem Überprüfungssignal wird anschließend der Signalpfad durchlaufen und analog der Ermittlung eines Messwertes im eigentlichen Messbetrieb des Feldgerätes ein Messwert ermittelt. Dieser wird dann mit einem für den Signalpfad zuvor bereits ermittelten Vergleichswert in der Form verglichen, dass bei einer Abweichung größer eines für den Vergleichswert festgelegten Toleranzbereiches eine Zustandsveränderung des Signalpfades detektiert wird.

Gemäß einer vorteilhaften Ausführungsform kann vorgesehen sein, dass der für den Signalpfad ermittelte Vergleichswert während der Fertigung der elektronischen Sensorschaltung ermittelt wird und zum Überprüfen auf den während der Fertigung der elektronischen Sensorschaltung ermittelten Vergleichswert zugegriffen wird. Insbesondere kann die Ausführungsform vorsehen, dass der während der Fertigung der elektronischen Sensorschaltung ermittelte Vergleichswert in einem Speicherelement auf der elektronischen Sensorschaltung hinterlegt wird.

Gemäß einer vorteilhaften Ausführungsform kann vorgesehen sein, dass das an dem Ausgang des Wandlerelements angelegte Überprüfungssignal durch ein Spannungssignal realisiert wird. Insbesondere kann die Ausführungsform vorsehen, dass das Spannungssignal durch den digitalen Prozessor erzeugt wird.

Gemäß einer alternativen Ausführungsform kann vorgesehen sein, dass das Spannungssignal mit Hilfe zumindest einer auf der elektronischen Sensorschaltung vorgesehenen Kapazität erzeugt wird.

Gemäß einer vorteilhaften Ausführungsform kann vorgesehen sein, dass das Ersetzen der analogen Rohmesswerte an dem Ausgang des Wandlerelements durch das analoge Überprüfungssignal von dem digitalen Prozessor oder einem weiteren digitalen Prozessor initiiert bzw. gesteuert wird.

Gemäß einer vorteilhaften Ausführungsform kann vorgesehen sein, dass das Überprüfen des ermittelten Messwertes mit dem für den Signalpfad ermittelten Vergleichswert durch den digitalen Prozessor oder einen weiteren digitalen Prozessor durchgeführt wird.

Gemäß einer vorteilhaften Ausführungsform kann vorgesehen sein, dass in dem Fall, dass eine Veränderung des Zustandes des Signalpfads festgestellt wird, diese Veränderung signalisiert wird.

Gemäß einer vorteilhaften Ausführungsform kann vorgesehen sein, dass nach dem Überprüfen des ermittelten Messwertes mit einem für den Signalpfad ermittelten Vergleichswert wieder in den Messbetrieb zurückgekehrt wird, sofern der für das analoge Überprüfungssignal ermittelte Messwert innerhalb des für den Vergleichswert festgelegten Toleranzbereiches liegt.

Gemäß einer weiteren vorteilhaften Ausführungsform kann vorgesehen sein, dass vor dem Durchlaufen des Signalpfads mit dem analogen Überprüfungssignal der Signalpfad auf den Analog-Digital-Konverter konditioniert wird, insbesondere ein Gain und/oder Offset angepasst wird.

Die Erfindung wird anhand der nachfolgenden Zeichnung näher erläutert. Es zeigt:

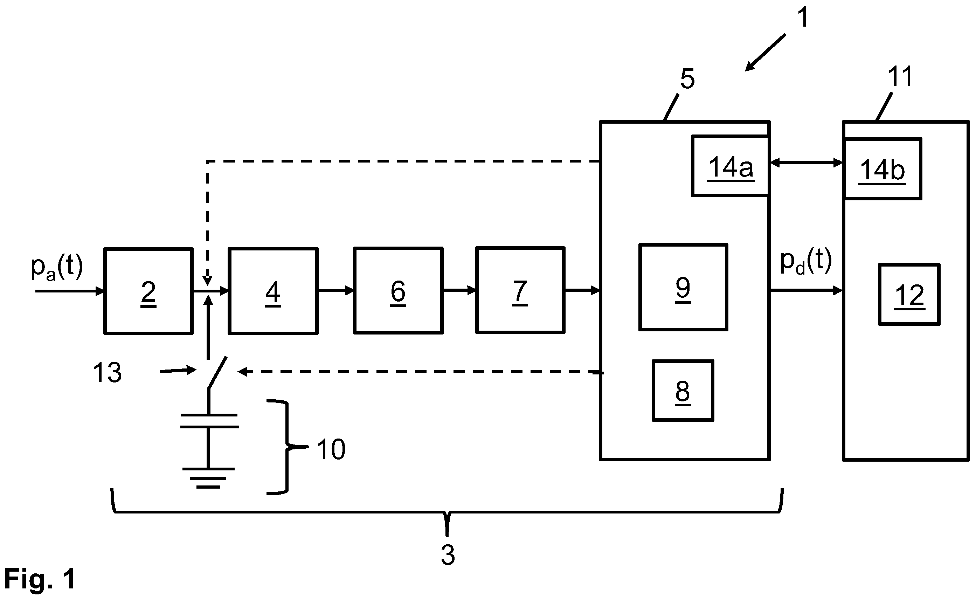

Fig. 1: eine schematische Darstellung einer erfindungsgemäßen elektronischen Sensorschaltung für ein Feldgerät der Automatisierungstechnik.

Figur 1 zeigt eine erfindungsgemäße elektronische Sensorschaltung 1 zum Erfassen von analogen Rohmesswerten einer Prozessgröße, beispielsweise Druckmesswerte, und zum Verarbeiten der erfassten Rohmesswerte zu einem digitalen Messwert. Die elektronische Sensorschaltung 1 umfasst dabei folgende Komponenten: ein Wandlerelement 2 zum Erfassen der Prozessgröße und Wandeln der Prozessgröße in analoge Rohmesswerte, eine Vorverstärkereinheit 4 zur Signalkonditionierung, einen Analog-Digital-Konverter 6 zum Wandeln des analogen Signals in ein digitales Signals und einen digitalen Prozessor 5, beispielsweise einen digitalen Signalprozessor zur Ausgabe der digitalen, insbesondere auch kompensierten Messwerte.

Die Komponenten bilden dabei einen Signalpfad von dem Wandlerelement 2 zu dem digitalen Prozessor 5. Der Signalpfad muss neben dem Wandlerelement 2 und dem digitalen Prozessor 5 zumindest den Analog-Digital-Konverter 6, welcher die von dem Wandlerelement 2 stammenden analogen Rohmesswerte in digitale Rohmesswerte wandelt, umfassen.

Das Wandlerelement ist dazu eingerichtet, eine Prozessgröße in Form von Rohmesswerten zu erfassen und entsprechende analoge Rohmesswerte, d.h. analoge Messwerte, die noch keine Kompensation erfahren haben, auszugeben. Bei dem Wandlerelement kann es sich beispielsweise um ein Druckwandlerelement handeln, welches einen sich zeitlich veränderlichen Druck pₐ(t) in Form von analogen Rohmesswerten ausgibt. Die Erfindung ist dabei nicht auf Druckwandlerelemente beschränkt, sondern kann auch auf Feldgeräte mit anderen Wandlerelementen übertragen werden.

Um eine Konditionierung, insbesondere eine Pegelanpassung des vom Wandlerelement kommenden Signals durchzuführen, kann, wie in Fig. 1 dargestellt, der Signalpfad 3 auch die Vorverstärkereinheit 4 umfassen. Diese ist in dem Signalpfad zwischen dem Wandlerelement 2 und dem Analog-Digital-Konverter 6 angeordnet. Durch die Konditionierung wird das von dem Wandlerelement stammende Signal an einen Eingangsbereich des nachgeschalteten Analog-Digital-Konverters 6 angepasst, insbesondere werden Gain und/oder Offset angepasst.

Durch den, nach der Vorverstärkereinheit 4 angeordneten, Analog-Digital-Konverter 6, werden die analogen Rohmesswerte von dem Wandlerelement 2 in digitale Rohmesswerte gewandelt. Beispielsweise kann der Analog-Digital-Konverter 6 als 24 Bit Analog-Digital-Konverter ausgestaltet sein.

Ferner kann der Signalpfad zumindest ein Filterelement 7 umfassen. Bei dem mit Bezugszeichen 7 bezeichneten Komponente kann es sich um ein hardwaremäßig ausgebildetes Filterelement 7, beispielsweise ein SINC 3 Filterelement handeln. Das hardwaremäßig ausgebildete Filterelement 7 ist in dem Signalpfad 3 zwischen dem Analog-Digital-Konverter 6 und dem digitalen Prozessor 5 angeordnet, so dass er die digitalisierten Rohmesswerte filtert. Alternativ kann das hardwaremäßig ausgebildete Filterelement auch durch ein intern auf dem digitalen Prozessor softwaremäßig abgebildetes Filterelement 9 realisiert sein.

Die über den Analog-Digital-Konverter 6 digitalisierten und ggfl. auch gefilterten Rohmesswerte sind dem digitalen Prozessor 5 zur Weiterverarbeitung zugeführt. Der Prozessor 5 ist dazu eingerichtet, mit Hilfe eines Algorithmus die digitalen Rohmesswerte weiterzuverarbeiten. Hierbei kann über den digitalen Prozessor eine Reihe von Operationen mit den Rohmesswerten durchgeführt werden. Beispielsweise kann eine Temperaturkompensation der Rohmesswerte durchgeführt werden, umso ein temperaturkompensiertes digitales Ausgangssignal in Form von Messwerten zu erhalten.

Die zuvor beschriebene elektronische Sensorschaltung 1 kann vorzugsweise in einem Feldgerät der Automatisierungstechnik eingesetzt werden. Beispielsweise kann ein Mediendruck durch das Wandlerelement der Sensorschaltung des Feldgerätes in analoge Rohmesswerte gewandelt werden, welche wie zuvor beschrieben, durch die Sensorschaltung digitalisiert und anschließend zu einem kompensierten Druckmesswert, beispielsweise durch Temperaturkompensation, weiterverarbeitet werden.

Um den Signalpfad der elektronischen Sensorschaltung zu überprüfen und somit einen negativen Effekt auf die Messfunktion bzw. die Messgenauigkeit im eigentlichen Messbetrieb des Feldgerätes zu verhindern, sieht das erfindungsgemäße Verfahren folgende Schritte vor:
In einem ersten Schritt wird der eigentliche Messbetrieb unterbrochen, d.h. es werden keine von dem Wandlerelement 2 stammenden analogen Rohmesswerte mehr über den Signalpfad übertragen. Die Unterbrechung des Messbetriebes kann beispielsweise durch den digitalen Prozessor initiiert werden. Alternativ kann die Unterbrechung aber auch durch den weiteren Prozessor 12 der Hauptelektronik 11 initiiert werden.

In einem zweiten Schritt werden die analogen Rohmesswerte an dem Ausgang des Wandlerelements durch ein analoges Überprüfungssignal ersetzt. Das Überprüfungssignal kann beispielsweise ein Spannungssignal sein. Das Spannungssignal kann entweder durch den digitalen Prozessor 5 selbst oder mit Hilfe einer auf der elektronischen Sensorschaltung 1 zusätzlich vorgesehenen Kapazität erzeugt werden. In dem Fall, dass der digitale Prozessor selbst das Spannungssignal bereitstellt, kann dieses wie in Fig. 1 exemplarisch durch eine gestrichelte Linie dargestellt, von einem Ausgang des Prozessors zu dem Ausgang des Wandlerelements geführt sein. In dem Fall, dass das Spannungssignal mit Hilfe der Kapazität erzeugt wird, wird durch die Kapazität quasi eine "Simulation" der Werte am Ausgang des Wandlerelementes realisiert. Hierzu kann die Kapazität auf einen spezifischen Wert, bspw. einen maximalen Ladewert, geladen werden, so dass über der Kapazität eine Spannung entsteht, welche dann als Spannungssignal dient. Das Ersetzen der analogen Rohmesswerte an dem Ausgang des Wandlerelements 2 kann durch ein oder mehrere auf der Sensorschaltung zusätzlich vorgesehene Schaltelemente 13 realisiert werden. Dies kann, wie in Fig. 1 dargestellt, durch mehrere einzelne (einpolige) Schalter oder aber auch durch einen mehrpoligen Schalter, der zwischen dem von einem Ausgang des Prozessors 5 stammenden Spannungssignal, dem mit Hilfe der Kapazität 10 erzeugten Spannungssignal und dem im Messbetrieb von dem Wandlerelement 2 stammenden analogen Rohmesswert umschaltet, erfolgen. Die Ansteuerung des oder der Schaltelemente kann durch den digitalen Prozessor der Sensorschaltung erfolgen, der in dem Fall, dass eine Überprüfung des Singalpfades erfolgen soll, das Schaltelement 13 entsprechend ansteuert und somit die Sensorschaltung 1 für die Überprüfung konfiguriert. Alternativ kann die Ansteuerung des oder der Schaltelemente 13 auch durch den weiteren digitalen Prozessor 12, der beispielsweise auf einer abgesetzt von der Sensorschaltung 1 angeordneten Hauptelektronik 11 sitzt, erfolgen. In Fig. 1 ist die Ansteuerung des Schaltelements 13 durch den digitalen Prozessor 5 der Sensorelektronik 1 exemplarisch durch einen gestrichelten Pfeil dargestellt. Zur Kommunikation der Sensorschaltung 1 mit der Hauptelektronik 11 weisen diese zueinander komplementär ausgebildete, insbesondere digitale Kommunikationsschnittellen 14a und 14b auf.

In einem daran anschließenden dritten Schritt wird der Signalpfad mit dem analogen Überprüfungssignal durchlaufen. Dies bedeutet das analoge Überprüfungssignal wird durch den Vorverstärker, falls vorhanden, entsprechend konditioniert, anschließend durch den analog-digital Konverter 6 in ein digitales Signal gewandelt, durch das software- oder hardwaremäßig ausgebildete Filterelement, falls vorhanden, gefiltert und anschließend durch den digitalen Prozessor mit Hilfe des Algorithmus zu einem Überprüfungswert weiterverarbeitet. Das Überprüfungssignal durchläuft den Signalpfad also auf dieselbe Art und Weise wie die im Messbetrieb von dem Wandlerelement stammenden Rohmesswerte.

In einem daran anschließenden vierten Schritt wird der zuvor ermittelte Überprüfungswert mit einem für den Signalpfad 3 ermittelten Vergleichswert verglichen. In dem Fall, dass der für das analoge Überprüfungssignal ermittelte Überprüfungswert um einen vorgegebenen Betrag von dem Vergleichswert abweicht, wird eine Veränderung des Zustandes des Signalpfads 3 festgestellt. Diese Veränderung des Zustandes des Signalpfads 3 kann dann signalisiert werden, beispielsweise durch die Ausgabe einer Fehlermeldung auf einem Display des Feldgerätes.

Der vorgegebene Betrag kann entweder von einem Bediener, bspw. durch entsprechende Konfiguration bzw. Parametrierung des Feldgerätes vorgegeben werden oder alternativ durch den Feldgerätehersteller, beispielsweise während der Herstellung des Feldgerätes bzw. der elektronischen Sensorschaltung. Der Vergleichswert kann beispielsweise während der Fertigung der elektronischen Sensorschaltung für genau diesen Signalpfad ermittelt werden und für die später im eigentlichen Messbetrieb stattfindende Überprüfung herangezogen werden. Um später, also im eigentlichen Messbetrieb, auf den Vergleichswert zugreifen zu können, kann dieser in einem Speicherelement 8 der elektronischen Sensorschaltung während der Fertigung abgelegt bzw. gespeichert werden. Das Speicherelement 8 kann dabei, wie in Fig. 1 dargestellt, sowohl ein Speicherbereich des digitalen Prozessors als auch ein separat ausgebildeter Speicherbaustein auf der Sensorelektronik sein.

In einem letzten Schritt sieht das Verfahren vor, dass nach dem Überprüfen des ermittelten Überprüfungswerts mit einem für den Signalpfad ermittelten Vergleichswert, die elektronische Sensorschaltung wieder in den eigentlichen Messbetrieb zurückkehrt, sofern der für das analoge Überprüfungssignal ermittelte Überprüfungswert nicht um den vorgegebenen Betrag von dem Vergleichswert abweicht.

### Bezugszeichenliste

- 1: Elektronische Sensorschaltung
- 2: Wandlerelement
- 3: Signalpfad
- 4: Vorverstärkereinheit
- 5: Digitaler Prozessor, insb. digitaler Signalprozessor
- 6: Analog-Digital-Konverter
- 7: Hardwaremäßig ausgebildetes Filterelement
- 8: Speicherelement
- 9: Softwaremäßig ausgebildetes Filterelement
- 10: Kapazität
- 11: Hauptelektronik
- 12: Weiterer digitaler Prozessor
- 13: Schaltelement
- 14a, 14b: Kommunikationsschnittstelle

## Patentansprüche

1. Verfahren zum Überprüfen eines Signalpfades einer elektronischen Sensorschaltung (1) für ein Feldgerät der Automatisierungstechnik, wobei die Sensorschaltung (1) wenigstens einen Signalpfad (3) mit zumindest einem Wandlerelement (2) zum Erfassen, Wandeln und Ausgeben einer Prozessgröße an einem Ausgang des Wandlerelements (2) in Form von analogen Rohmesswerten, einem dem Wandlerelement nachgeschalteten Analog-Digital-Konverter (6) zum Wandeln der analogen Rohmesswerte in digitale Rohmesswerte und einem dem Analog-Digital-Konverter nachgeschalteten digitalen Prozessor (5), insbesondere einen digitalen Signalprozessor, dem die digitalisierten Rohmesswerte zugeführt sind und der digitale Prozessor dazu eingerichtet ist, in einem Messbetrieb, die digitalisierten Rohmesswerte zu Messwerten weiterzuverarbeiten, umfasst und das Verfahren folgende Schritte vorsieht:
- Unterbrechen des Messbetriebes;
- Ersetzen der analogen Rohmesswerte an dem Ausgang des Wandlerelements (2) durch ein analoges Überprüfungssignal;
- Durchlaufen des Signalpfads (3) mit dem analogen Überprüfungssignal, so dass der digitale Prozessor (5) einen für das analoge Überprüfungssignal entsprechenden Messwert ermittelt;
- Überprüfen des ermittelten Messwertes mit einem für den Signalpfad (3) ermittelten Vergleichswert, wobei in dem Fall, dass der für das analoge Überprüfungssignal ermittelte Messwert außerhalb eines für den Vergleichswert festgelegten Toleranzbereiches liegt, eine Veränderung des Zustandes des Signalpfads (3) festgestellt wird.

2. Verfahren nach Anspruch 1, wobei der für den Signalpfad ermittelte Vergleichswert während der Fertigung der elektronischen Sensorschaltung (1) ermittelt wird und zum Überprüfen auf den während der Fertigung der elektronischen Sensorschaltung (1) ermittelten Vergleichswert zugegriffen wird.

3. Verfahren nach dem vorhergehenden Anspruch, wobei der während der Fertigung der elektronischen Sensorschaltung (1) ermittelte Vergleichswert in einem Speicherelement (8) auf der elektronischen Sensorschaltung (2) hinterlegt wird.

4. Verfahren nach einem oder mehreren der vorhergehenden Ansprüche, wobei das an dem Ausgang des Wandlerelements (2) angelegte Überprüfungssignal durch ein Spannungssignal realisiert wird.

5. Verfahren nach dem vorhergehenden Anspruch, wobei das Spannungssignal durch den digitalen Prozessor (5) erzeugt wird.

6. Verfahren nach einem der Ansprüche 1 bis 4, wobei das Spannungssignal mit Hilfe zumindest einer auf der elektronischen Sensorschaltung (1) vorgesehenen Kapazität (10) erzeugt wird.

7. Verfahren nach einem oder mehreren der vorhergehenden Ansprüche, wobei das Ersetzen der analogen Rohmesswerte an dem Ausgang des Wandlerelements (2) durch das analoge Überprüfungssignal von dem digitalen Prozessor (5) oder einem weiteren digitalen Prozessor initiiert bzw. gesteuert wird.

8. Verfahren nach einem oder mehreren der vorhergehenden Ansprüche, wobei das Überprüfen des ermittelten Messwertes mit dem für den Signalpfad (3) ermittelten Vergleichswert durch den digitalen Prozessor (5) oder einen weiteren digitalen Prozessor durchgeführt wird.

9. Verfahren nach einem oder mehreren der vorhergehenden Ansprüche, wobei in dem Fall, dass eine Veränderung des Zustandes des Signalpfads (3) festgestellt wird, diese Veränderung signalisiert wird.

10. Verfahren nach einem oder mehreren der vorhergehenden Ansprüche, wobei nach dem Überprüfen des ermittelten Messwertes mit einem für den Signalpfad ermittelten Vergleichswert wieder in den Messbetrieb zurückgekehrt wird, sofern der für das analoge Überprüfungssignal ermittelte Messwert innerhalb des für den Vergleichswert festgelegten Toleranzbereiches liegt.

11. Verfahren nach einem oder mehreren der vorhergehenden Ansprüche, wobei vor dem Durchlaufen des Signalpfads (3) mit dem analogen Überprüfungssignal eine Pegelanpassung des von dem Wandlerelement kommenden Signals durchgeführt wird, insbesondere ein Gain und/oder Offset angepasst wird.

## Claims

1. Method for checking a signal path of an electronic sensor circuit (1) for a field device in automation technology, wherein the sensor circuit (1) comprises at least one signal path (3) with at least one converter element (2) for detecting, converting, and outputting a process variable at an output of the converter element (2) in the form of analog raw measurement values, an analog-to-digital converter (6) downstream of the converter element for converting the analog raw measurement values into digital raw measurement values, and a digital processor (5) downstream of the analog-to-digital converter, in particular a digital signal processor, to which the digitized raw measurement values are supplied and which is configured to process the digitized raw measurement values into measured values during a measurement operation,
the method comprising the following steps:
• interrupting the measurement operation;
• replacing the analog raw measurement values at the output of the converter element (2) with an analog test signal;
• passing the analog test signal through the signal path (3), so that the digital processor (5) determines a measured value corresponding to the analog test signal;
• checking the determined measured value against a reference value determined for the signal path (3), wherein, if the measured value determined for the analog test signal lies outside a defined tolerance range for the reference value, a change in the state of the signal path (3) is detected.

2. Method according to claim 1, wherein the reference value determined for the signal path is established during the manufacturing of the electronic sensor circuit (1), and the reference value determined during manufacturing is accessed for the check.

3. Method according to the preceding claim, wherein the reference value determined during manufacturing of the electronic sensor circuit (1) is stored in a memory element (8) on the electronic sensor circuit (2).

4. Method according to one or more of the preceding claims, wherein the test signal applied at the output of the converter element (2) is implemented as a voltage signal.

5. Method according to the preceding claim, wherein the voltage signal is generated by the digital processor (5).

6. Method according to one of claims 1 to 4, wherein the voltage signal is generated using at least one capacitor (10) provided on the electronic sensor circuit (1).

7. Method according to one or more of the preceding claims, wherein the replacement of the analog raw measurement values at the output of the converter element (2) with the analog test signal is initiated or controlled by the digital processor (5) or another digital processor.

8. Method according to one or more of the preceding claims, wherein the checking of the determined measured value against the reference value determined for the signal path (3) is carried out by the digital processor (5) or another digital processor.

9. Method according to one or more of the preceding claims, wherein, if a change in the state of the signal path (3) is detected, this change is signaled.

10. Method according to one or more of the preceding claims, wherein, after checking the determined measured value against the reference value determined for the signal path, the measurement operation is resumed, provided that the measured value determined for the analog test signal lies within the defined tolerance range for the reference value.

11. Method according to one or more of the preceding claims, wherein, before passing the analog test signal through the signal path (3), a level adjustment of the signal coming from the converter element is performed, in particular a gain and/or offset is adjusted.

## Revendications

1. Procédé de vérification d'un chemin de signal d'un circuit capteur électronique (1) destiné à un appareil de terrain en technologie d'automatisation, le circuit capteur (1) comprenant au moins un chemin de signal (3) avec au moins un élément de conversion (2) pour détecter, convertir et délivrer une grandeur de procédé à une sortie de l'élément de conversion (2) sous forme de valeurs brutes analogiques, un convertisseur analogique-numérique (6) connecté en aval de l'élément de conversion pour convertir les valeurs brutes analogiques en valeurs brutes numériques, et un processeur numérique (5) connecté en aval du convertisseur analogique-numérique, notamment un processeur de signal numérique, auquel les valeurs brutes numérisées sont transmises, le processeur numérique étant conçu pour traiter les valeurs brutes numérisées en valeurs mesurées pendant un mode de mesure,
le procédé comprenant les étapes suivantes :
• interruption du mode de mesure ;
• remplacement des valeurs brutes analogiques à la sortie de l'élément de conversion (2) par un signal de vérification analogique ;
• passage du signal de vérification analogique à travers le chemin de signal (3), de sorte que le processeur numérique (5) détermine une valeur mesurée correspondant au signal de vérification analogique ;
• vérification de la valeur mesurée déterminée avec une valeur de référence déterminée pour le chemin de signal (3), une modification de l'état du chemin de signal (3) étant détectée si la valeur mesurée déterminée pour le signal de vérification analogique se situe en dehors d'une plage de tolérance définie pour la valeur de référence.

2. Procédé selon la revendication 1, dans lequel la valeur de référence déterminée pour le chemin de signal est établie pendant la fabrication du circuit capteur électronique (1), et cette valeur de référence est utilisée pour la vérification.

3. Procédé selon la revendication précédente, dans lequel la valeur de référence déterminée pendant la fabrication du circuit capteur électronique (1) est stockée dans un élément de mémoire (8) sur le circuit capteur électronique (2).

4. Procédé selon une ou plusieurs des revendications précédentes, dans lequel le signal de vérification appliqué à la sortie de l'élément de conversion (2) est réalisé par un signal de tension.

5. Procédé selon la revendication précédente, dans lequel le signal de tension est généré par le processeur numérique (5).

6. Procédé selon l'une des revendications 1 à 4, dans lequel le signal de tension est généré à l'aide d'au moins une capacité (10) prévue sur le circuit capteur électronique (1).

7. Procédé selon une ou plusieurs des revendications précédentes, dans lequel le remplacement des valeurs brutes analogiques à la sortie de l'élément de conversion (2) par le signal de vérification analogique est initié ou contrôlé par le processeur numérique (5) ou un autre processeur numérique.

8. Procédé selon une ou plusieurs des revendications précédentes, dans lequel la vérification de la valeur mesurée déterminée avec la valeur de référence du chemin de signal (3) est effectuée par le processeur numérique (5) ou un autre processeur numérique.

9. Procédé selon une ou plusieurs des revendications précédentes, dans lequel, en cas de détection d'une modification de l'état du chemin de signal (3), cette modification est signalée.

10. Procédé selon une ou plusieurs des revendications précédentes, dans lequel, après la vérification de la valeur mesurée déterminée avec la valeur de référence du chemin de signal, le mode de mesure est repris, à condition que la valeur mesurée déterminée pour le signal de vérification analogique se situe dans la plage de tolérance définie pour la valeur de référence.

11. Procédé selon une ou plusieurs des revendications précédentes, dans lequel, avant le passage du signal de vérification analogique à travers le chemin de signal (3), un ajustement de niveau du signal provenant de l'élément de conversion est effectué, notamment un ajustement du gain et/ou du décalage (offset).
